# EUROPEAN PATENT SPECIFICATION

(11) **EP 1 127 404 B1**
(45) Date of publication and mention of the grant of the patent: **29.01.2003**
(21) Application number: 99947608.8
(22) Date of filing: 17.09.1999
(51) Int. Cl.: H03B 5/12

(54) **TRANSISTOR OSCILLATOR USING A VOLTAGE STEP-UP CIRCUIT**
TRANSISTOR-OSZILLATOR UNTER VERWENDUNG EINER SPANNUNGSERHÖHUNGSSCHALTUNG
CIRCUIT COMBINANT LES FONCTIONS D'UN OSCILLATEUR ET LA FOURNITURE D'UNE TENSION EN ECHELON

(30) Priority: 30.10.1998 GB 9823657
(43) Date of publication of application: 29.08.2001
(73) Proprietor: THE SECRETARY OF STATE FOR DEFENCE, London SW1A 2HB (GB)
(72) Inventor: GARDNER, John, Reading,Berkshire RG7 4PR (GB)
(74) Representative: Skelton, Stephen Richard
(86) International application number: GB9903086
(87) International publication number: WO00027025

(56) References cited:
- CH-A- 450 499
- DE-A- 2 334 094
- FR-A- 2 102 180
- US-A- 3 506 919

## Description

The present invention relates to a simplified circuit for providing both the function of an oscillator and for providing voltage step-up.

Several different types of oscillator circuit are well known and documented, such as DE 23 34 094 A (Stanley Denki K.K.), Pierce, Colpitts & Clapp as detailed in 'Transistor Circuit Design' McGraw Hill P308/309, 'Electronics for the Physicist' CFG Delaney (1980) P178 and 'The Art of Electronics' Horowitz and Hill (2nd Edition) P297/298. These circuits are typically less efficient than the oscillator/step-up according to the invention and will require to use more components, often relying on high value inductors or additional transformers to achieve any voltage step-up. DE 23 34 094 A operates as a proximity sensor using two inductor coils which resonate in the close proximity of a metallic element. However the output is a noisy AC signal and not a pure sine wave.

The oscillator/step-up circuit according to the present invention has been designed for use in contamination monitors, specifically radiation monitors and in particular in portable radiation monitors for detecting α or β particles. In order for such devices to be used in certain circumstances they are required to gain BASEEFA (British Approval Service for Electrical Equipment for use in Flammable Atmospheres) certification, meaning that it is designated safe for use in an explosive environment. Use of high value inductors or high inductance transformers results in high values of stored charge, however transiently, which complicates BASEEFA certification as the circuit then has to be well shielded against the ingress of the explosive atmosphere due to the risk of "sparking". The circuit according to the present invention reduces this problem by its simplified design.

Accordingly, the present invention provides an oscillator circuit for providing a step-up or step-down output in the form of an AC signal, the oscillator circuit having an inductor (2), means for supplying energy to the inductor (2) and two capacitors (3, 4) that tap directly into the AC signal to provide a phase shift and act as a voltage divider, the oscillator circuit characterised in that the inductor is tapped so as to provide a substantially pure sine wave step-up or step-down voltage and phase inversion feedback.

An embodiment of the oscillator/step-up circuit according to the invention can be constructed with only five components: an inductor, a transistor to control the supply of energy into the inductor, a resistor for providing a bias current to the transistor and two capacitors to provide the phase shift for the oscillator and to act as a voltage divider for the transistor.

The main difference between the oscillator/step-up circuit of the invention and those of the prior art is that the inductor is over-wound or tapped, which provides both the step-up voltage (dependant upon the turns ratio) and phase inversion feedback.

In practice the over-wound inductor can be formed by providing two separate windings on the same former to provide the turns ratio. They can then be electrically connected. Where they connect is the tap - one winding forming the primary winding and the other forming the secondary winding.

Obviously the step-up voltage, which is dependent on the turns ratio, can be configured to be a step-down voltage should this be required.

In known sine wave oscillator circuits the transistor must not be allowed to reach saturation as this distorts the output signal, giving the sine wave a flat profile at the extremes of the peaks and troughs. Thus, in known circuits a biasing system is used to ensure that the transistor does not saturate and the sine wave stays within range. In the oscillator/step-up circuit according to the invention, saturation of the transistor is preferred as this ensures that the circuit provides a guaranteed output voltage.

Due to the load on the oscillator/step-up circuit and the losses in the inductor, energy needs to be continuously injected into the circuit. This is best achieved by injecting energy in the form of a sine wave. In the oscillator/step-up circuit according to the invention, a magnetic field is injected into the inductor via the additional turns on the inductor. To ensure that the sine wave signal from the circuit remains clean, the current is injected when the signal is at maximum, ensuring that the circulating current dominates that being injected. The transistor controls the timing of the injection, such that current is injected at the minimum collector voltage of the circuit.

As the energy injection is made directly into the inductive part of the oscillator/step-up circuit, it is possible to inject pulsed direct current into the inductor without a biasing circuit. The feedback from the AC side of the oscillator/step-up circuit (tapped down from the main tuning capacitor) is used to drive the transistor and control the timing of the energy injection. There is no requirement for phase inversion as required in the prior art devices, as this is already achieved by the over-winding or tapping of the inductor. In known oscillator circuits, the transistor is maintained under critical conditions (working under a class A system) and thus the base of the transistor operates at a signal level of a few millivolts, which requires the addition of a complex biasing circuit.

An advantage of the oscillator/step-up circuit according to the invention is the reduction in the number of components required in the circuit and hence the space it occupies on the circuit board. The circuit is also extremely efficient as it does not require a resistive divider, enabling the circuit to only feed energy back into the oscillator for part of the cycle, to top up the small losses and maintain any load current supplied. Use of the oscillator/step-up circuit according to the invention avoids the requirement for high value inductors or high inductance transformers normally associated with HV generation.
This avoids the problems of high values of stored charge, as previously described, which would complicate BASEEFA approval.

An embodiment of the invention will now be described, by way of example, with reference to the accompanying drawing, wherein

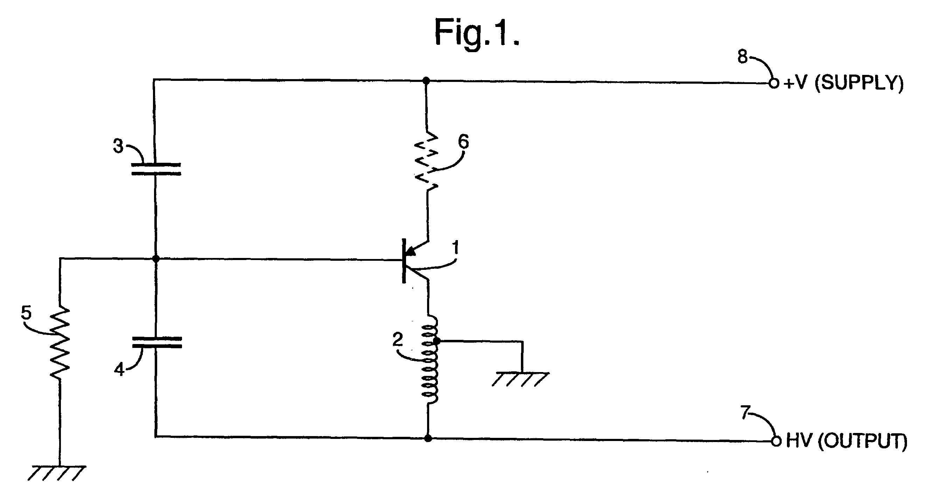

Fig. 1 shows a circuit diagram of the oscillator/step-up circuit according to the present invention.

Referring to fig. 1, the oscillator/step-up circuit comprises a transistor 1, an inductor 2 which is over-wound or tapped to provide a primary and secondary winding, a voltage divider formed from two capacitors 3 and 4 and a resistor 5 which provides a trickle feed to the transistor 1. The resistor 6 is optional and is not required for operation of the oscillator/step-up circuit.

The oscillator/step-up circuit is supplied via terminal 8 and earth and provides a power signal via terminal 7 and earth. In use, terminal 8 is connected to a suitable DC power supply (such as a battery). In order to operate, the oscillator/step-up circuit needs a start up excitation. Resistor 5 trickle feeds the transistor 1, which is thus slightly biased. When the transistor is in this state, any noise is sufficient to excite the oscillator/step-up circuit. The primary winding of the inductor 2 and the capacitors 3 and 4 provide the sine wave output. The secondary winding of the inductor 2 provides the necessary excitation to start up the oscillator/step-up circuit by tapping into the low impedance point on the primary winding. The transistor 1 acts as a switch to control energy injection into the circuit. Injection of the magnetic field into the inductor 2 occurs when the transistor 1 is at 0 v and the circuit is at maximum voltage to minimise any effect on the circuit characteristics. The two capacitors 3 and 4 tap directly into the AC signal and act as a voltage divider to reduce the voltage to that suitable to operate the transistor 1.

When the oscillator/step-up circuit is incorporated into the αβ monitor an additional resistor 6 is included in the circuit. This resistor is used to ensure the oscillator/step-up does not 'squegg', i.e. switch itself off periodically. The αβ monitor is designed such that the oscillator/step-up circuit does not need to provide a supply all the time - when not needed, it can be switched off by separate sensing and control circuitry.

## Claims

1. An oscillator circuit for providing a step-up or step-down output in the form of an AC signal, the oscillator circuit having an inductor (2), means for supplying energy to the inductor (2) and two capacitors (3, 4) that tap directly into the AC signal to provide a phase shift and act as a voltage divider, the oscillator circuit **characterised in that** the inductor is tapped so as to provide a substantially pure sine wave step-up or step-down voltage and phase inversion feedback.

2. An oscillator circuit according to claim 1 **characterised in that** the inductor (2) is a coil having a primary and secondary winding which provides the step-up or step-down depending on the turns ratio of the winding.

3. An oscillator circuit according to claim 1 or 2 **characterised in that** a transistor (1) is used for controlling the supply of energy to the inductor (2) and the two capacitors (3, 4) that act as a voltage divider control the base voltage supplied to the transistor (1).

4. An oscillator circuit according to claim 3 **characterised in that** a resistor (5) is included in the circuit for providing a bias current to the transistor (1).

5. An oscillator circuit as claimed in claim 3 or 4 **characterised in that** the transistor (1) is saturated to ensure that the circuit provides a guaranteed output voltage.

## Patentansprüche

1. Oszillatorschaltung für die Schaffung eines Erhöhungs- oder Verringerungs-Ausgangssignals in Form eines Wechselstromsignals, die einen Induktor (2), Mittel zum Zuführen von Energie zum Induktor (2) und zwei Kondensatoren (3, 4), die direkt das Wechselstromsignal anzapfen, um eine Phasenverschiebung zu erzielen und als Spannungsteiler zu wirken, aufweist, wobei die Oszillatorschaltung **dadurch gekennzeichnet ist, daß** der Induktor so angezapft ist, daß sich eine im wesentlichen reine Sinuswellen-Erhöhungs- oder Verringerungs-Spannung und eine Phasenumkehrungsrückkopplung ergeben.

2. Oszillatorschaltung nach Anspruch 1, **dadurch gekennzeichnet, daß** der Induktor (2) eine Spule mit einer Primärwicklung und einer Sekundärwicklung ist, die die Erhöhung oder Verringerung in Abhängigkeit vom Windungsverhältnis der Wicklungen ergeben.

3. Oszillatorschaltung nach Anspruch 1 oder 2, **dadurch gekennzeichnet, daß** ein Transistor (1) verwendet wird, um die Zufuhr von Energie zum Induktor (2) zu steuern, wobei die zwei Kondensatoren (3, 4), die wie ein Spannungsteiler wirken, die dem Transistor (1) zugeführte Basisspannung steuern.

4. Oszillator nach Anspruch 3, **dadurch gekennzeichnet, daß** die Schaltung einen Widerstand (5) enthält, um einen Vorstrom für den Transistor (1) zu schaffen.

5. Oszillatorschaltung nach Anspruch 3 oder 4, **dadurch gekennzeichnet, daß** der Transistor (1) gesättigt ist, um sicherzustellen, daß die Schaltung eine garantierte Ausgangsspannung bereitstellt.

## Revendications

1. Circuit oscillateur pour délivrer une sortie élévatrice de tension ou abaisseuse de tension sous la forme d'un signal AC, le circuit oscillateur ayant une bobine d'inductance (2), des moyens pour alimenter une énergie dans la bobine d'inductance (2) et deux condensateurs (3, 4) qui prélèvent directement dans le signal AC pour fournir un déphasage et agir en tant que diviseur de tension, le circuit oscillateur étant **caractérisé en ce que** la bobine d'inductance est branchée de manière à fournir une tension élevée ou abaissée d'onde sinusoïdale essentiellement pure et une rétroaction d'inversion de phase.

2. Circuit oscillateur selon la revendication 1, **caractérisé en ce que** la bobine d'inductance (2) est une bobine ayant un enroulement primaire et un enroulement secondaire qui permettent l'élévation de tension ou l'abaissement de tension en fonction du rapport de spires de l'enroulement.

3. Circuit oscillateur selon la revendication 1 ou 2, **caractérisé en ce qu'**un transistor (1) est utilisé pour commander une alimentation d'énergie dans la bobine d'inductance (2) et les deux condensateurs (3, 4) qui agissent en tant que diviseur de tension commandent la tension de base alimentée dans le transistor (1).

4. Circuit oscillateur selon la revendication 3, **caractérisé en ce qu'**une résistance (5) est incluse dans le circuit pour délivrer un courant de polarisation dans le transistor (1).

5. Circuit oscillateur selon la revendication 3 ou 4, **caractérisé en ce que** le transistor (1) est saturé pour s'assurer que le circuit fournit une tension de sortie garantie.
